Europäisches Patentamt

European Patent Office

Office européen des brevets

(11) Numéro de publication: **0 109 865**
**B1**

## FASCICULE DE BREVET EUROPÉEN

(45) Date de publication du fascicule du brevet:
08.04.87

(51) Int. Cl.⁴: **H 01 L 27/14,** H 01 L 31/02

(21) Numéro de dépôt: **83401785.7**

(22) Date de dépôt: **13.09.83**

(54) **Procédé de fabrication de circuits intégrés comportants des éléments du type grille-isolant-semiconducteur à au moins deux niveaux de grille.**

(30) Priorité: **21.09.82 FR 8215905**

(43) Date de publication de la demande:
**30.05.84 Bulletin 84/22**

(45) Mention de la délivrance du brevet:
**08.04.87 Bulletin 87/15**

(84) Etats contractants désignés:
**DE GB NL**

(56) Documents cité:
**EP-A-0 003 213**
**EP-A-0 028 022**
**FR-A-2 126 277**
**FR-A-2 152 347**
**FR-A-2 362 495**
**GB-A-2 009 506**

**PATENTS ABSTRACTS OF JAPAN, vol. 4, no. 175 (E-36) 657 , 3 décembre 1980, page 26 E 36**

(73) Titulaire: **THOMSON- CSF, 173, Boulevard Haussmann, F-75379 Paris Cedex 08 (FR)**

(72) Inventeur: **Chautemps, Jacques, THOMSON- CSF SCPI 173, bld Haussmann, F-75379 Paris Cedex 08 (FR)**
Inventeur: **Blanchard, Pierre, THOMSON- CSF SCPI 173, bld Haussmann, F-75379 Paris Cedex 08 (FR)**
Inventeur: **Descure, Pierre, THOMSON- CSF SCPI 173, bld Haussmann, F-75379 Paris Cedex 08 (FR)**

(74) Mandataire: **Ruellan- Lemonnier, Brigitte, THOMSON- CSF SCPI 19, avenue de Messine, F-75008 Paris (FR)**

EP 0 109 865 B1

LIBER, STOCKHOLM 1987

## Description

La présente invention concerne un procédé de fabrication de circuits intégrés comportant des éléments du type grille-isolant-semiconducteur à au moins deux niveaux de grilles.

Comme circuits utilisant le type d'éléments mentionnés ci-dessus, on connaît en particulier les dispositifs à transfert de charges ainsi que des circuits utilisant des éléments du type MOS (metal-oxyde-semiconducteur). De tels circuits sont actuellement bien connus de l'homme de métier et sont décrits, en particulier, dans l'ouvrage de C.H. SEQUIN et M. F. TOMPSETT intitulé "Charge transfer devices" ou dans l'article de J. L. BERGER et al. "Les dispositifs à transfert de charge" paru dans le Revue Technique THOMSON-CSF de Mars 1980. Dans les circuits ci-dessus, les grilles sont réalisées en un matériau conducteur qui peut être soit un métal tel que l'aluminium soit un métalloïde tel que du silicium polycristallin fortement dopé. Or les techniques de fabrication des circuits intégrés comportant des éléments du type grille-isolant-semiconducteur dans lesquels la grille est formée d'une couche de silicium polycristallin nécessitent de recouvrir la grille d'une couche de matériau isolant avant de pouvoir réaliser un autre niveau de grilles, cette couche pouvant être réalisée par oxydation thermique du silicium polycristallin. Avec ce procédé, on obtient ainsi des grilles relativement épaisses dont l'épaisseur est de plus difficilement contrôlable.

Ceci est particuliérement gênant dans le cas des dispositifs photosensibles semiconducteurs dans lesquels notamment les éléments photosensibles ou photodétecteurs sont du type grille-isolant-semiconducteur, tels que, en particulier, les dispositifs a transfert de charges dans lesquels le rayonnement lumineux est envoyé sur des registres à transfert de charges comportant le plus souvent plusieurs niveaux de grilles partiellement superposées.

En effet, dans les dispositifs de ce type, lorsque l'éclairement est réalisé sur la face avant du dispositif photosensible, les photons ont à traverser la grille et les isolants de la capacité formant le photodétecteur avant d'arriver dans le matériau semiconducteur pour y créer des paires électron-trou. Les couches ci-dessus doivent donc être réalisées en des matériaux transparents aux rayonnements à intégrer tels que le silicium polycristallin semi-transparent. Or, comme mentionné ci-dessus, il est difficile, en particulier avec un matériau de ce type, de réaliser une grille de faible épaisseur. Il en résulte donc une atténuation importante des rayons lumineux traversant la grille, en particulier pour les longueurs d'onde bleues.

La présente invention a pour but de remédier à ces inconvénients en fournissant un nouveau procédé de fabrication de grilles permettant de réaliser des grilles d'une épaisseur plus faible que les grilles actuellement utilisées lorsqu'il y a plusieurs niveaux de grilles.

La présente invention a pour objet un procédé de fabrication de circuits intégrés comportant des éléments du type grille-isolant-semiconducteur à au moins deux niveaux de grilles selon lequel:
- on réalise de manière habituelle dans le circuit intégré les zones d'isolement et/ou les implantations d'impuretés,
- on dépose sur la face supérieure du circuit une couche mince de silicium polycristallin dopé semi-transparent,
- on recouvre cette couche d'une couche d'un matériau isolant compatible présentant un indice de réfraction supérieur à 1,5,
- on délimite et grave par la technique habituelle un niveau de grilles,
- on réalise l'oxydation thermique latérale de la couche de silicium polycristallin de manière à obtenir une couche isolante permettant de réaliser un autre niveau d'électrodes.

D'autres caractéristiques et avantages de la présente invention apparaitront à la lecture de la description faite ci-aprés avec référence aux dessins ci-annexés dans lesquels:
- les figures 1a à 1e représentent des vues en coupe des principales étapes de réalisation d'un circuit intégré comportant une structure de grille conforme à l'art antérieur;
- les figures 2a à 2f représentent des vues en coupe des principales étapes de réalisation d'un circuit intégré comportant une structure de grille conforme à la présente invention.

Dans les dessins, les mêmes références désignent les mêmes éléments mais pour des raisons de clarté les cotes et proportions ne sont pas respectées. De plus, on a représenté comme circuit intégré un dispositif photosensible à transfert de charges du type C.C.D, mais il est évident pour l'homme de l'art que la présente invention peut aussi s'appliquer à la fabrication d'autres circuits intégrés comportant des éléments du type grille-isolant-semiconducteur, photosensibles ou non.

On rappelera que, de manière connue, un dispositif à transfert de charge du type C.C.D est constitué de plusieurs ensembles de capacités M.I.S (Métal-Isolant-Semiconducteur) juxtaposées formant des capacités de stockage et de transfert.

Conformément au procédé de l'art antérieur décrit à titre illustratif, on réalise sur un substrat semiconducteur 1 en silicium de type P par exemple, une première couche mince et continue 2 d'un matériau isolant tel que de l'oxyde de silicium ($SiO_2$), par exemple.

Cette couche d'oxyde de silicium est recouverte d'une deuxième couche 3 d'un matériau isolant qui n'est pas attaquable par les mêmes agents que la couche 2 et qui peut être constitué par exemple par du nitrure de silicium ($Si_3N_4$), si la couche 2 est réalisée en oxyde de silicium. De manière typique et pour favoriser la transmission des photons vers le substrat, l'épaisseur des couches 2 et 3 est choisie de manière a être d'environ 800 Å.

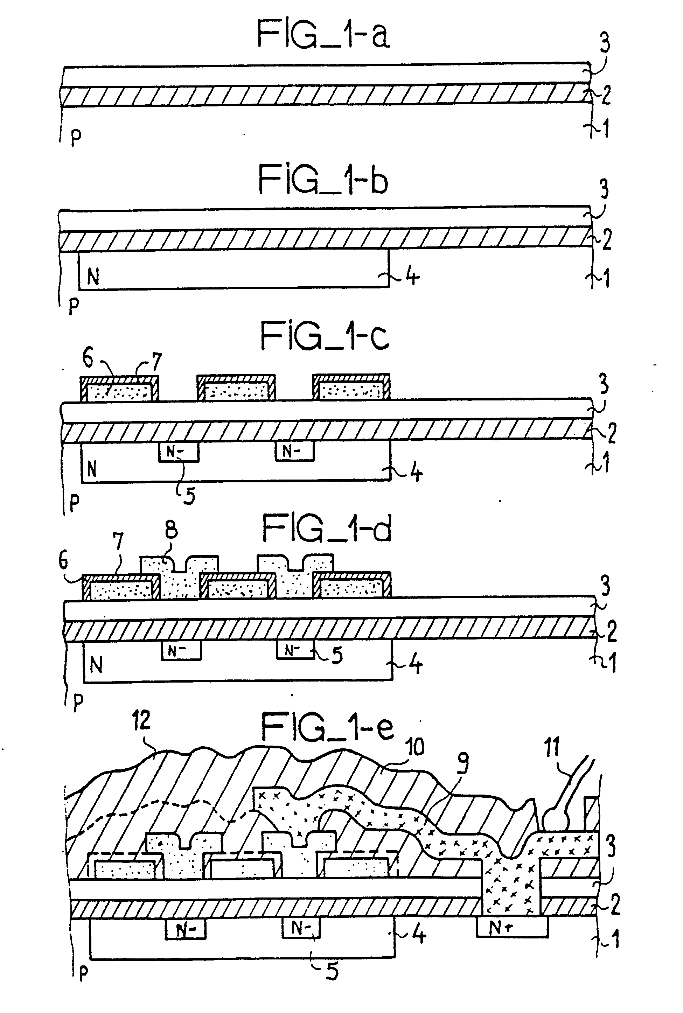

On réalise ensuite, les zones d'isolement séparant les divers canaux de transfert du dispositif photosensible. Pour cela, la plaquette de la figure 1a est recouverte d'une laque photosensible puis on délimite par photolithogravure les zones d'isolement et on élimine le nitrure de silicium sur ces zones. On réalise alors les zones d'isolement de différentes manières, soit en utilisant la technologie LOCOS par croissance d'oxyde à partir du substrat, soit par une diffusion d'impuretés du même type que celles du substrat avec une concentration d'impuretés supérieure à $10^{19}$ atomes/cm$^3$ ou bien par dépôt d'une couche relativement épaisse d'un matériau isolant tel que de l'oxyde de silicium.

Ensuite à l'aide d'un masque, on réalise par photolithogravure la délimitation du canal de transfert et on effectue alors un dopage en impuretés pour réaliser un canal enterré dans le cas d'un transfert en volume. Le transfert en volume est réalisé par une implantation d'impuretés de type opposé à celui du substrat, à savoir d'impuretés N à faible concentration.

Une fois la plaquette dans l'état représenté à la figure 1b par exemple, on réalise tout d'abord le premier niveau d'électrodes ou grilles dans le cas d'un dispositif à transfert de charges à deux niveaux d'électrodes. On effectue donc sur toute la surface de la plaquette, le dépôt d'une couche épaisse de 3000 à 5000 Å de silicium polycristallin convenablement dopé.

On délimite et grave par la technique habituelle de photolithogravure la couche de silicium polycristallin de manière à réaliser le premier niveau d'électrodes. Dans de nombreux cas, il est nécessaire d'effectuer une double gravure de la couche de silicium polycristallin afin de réparer les court-circuits qui se sont produits lors de la première gravure. Toutefois cette double gravure a pour principal inconvénient de dégrader la couche isolante. Une fois le premier niveau d'électrodes réalisé, on peut réaliser un dopage en impuretés pour obtenir des moyens de dissymétrie. De tels moyens de dissymétrie sont utilisés dans le cas d'un transfert unilatéral et réalisés par une implantation d'impuretés de même type que le substrat, localisée dans les intervalles formées par les capacités de transfert entre deux capacités de stockage. Comme représente à la figure 1c, il est possible de réaliser un canal enterré 4 comportant des moyens de dissymétrie 5. Ces moyens de dissymétrie obtenus par une implantation P de compensation donne un dopage N. Toutefois, il est aussi possible de réaliser le transfert unilatéral à l'aide d'une surépaisseur d'oxyde lors de la réalisation du second niveau d'électrodes. On réalise alors l'oxydation thermique du premier niveau de silicium polycristallin et l'on obtient le circuit représenté à la figure 1c présentant sur les électrodes 6 une couche 7 d'oxyde de silicium.

On réalise ensuite le deuxième niveau d'électrodes. Pour cela, on depose et on grave, en utilisant si nécessaire la technique de la double gravure, une couche épaisse de silicium polycristallin convenablement dopé de manière à délimiter le deuxième niveau d'électrodes 8. On oxyde alors par oxydation thermique le silicium polycristallin et l'on obtient le circuit représenté à la figure 1d.

On réalise ensuite de manière habituelle, en utilisant la technique de la photolithogravure, l'implantation des diodes, en particulier des diodes de lecture.

Puis on réalise de manière classique le dépôt d'une couche d'oxyde pyrolytique de 5000 Å à 1 µm. On ouvre ensuite les contacts. On dépose alors une couche d'aluminium que l'on grave en vue de réaliser les interconnexions 9. La plaquette est alors recouverte d'une couche de passivation 10 que l'on grave pour réaliser les plots de soudure 11 et la zone photosensible 12 comme représenté à la figure 1e.

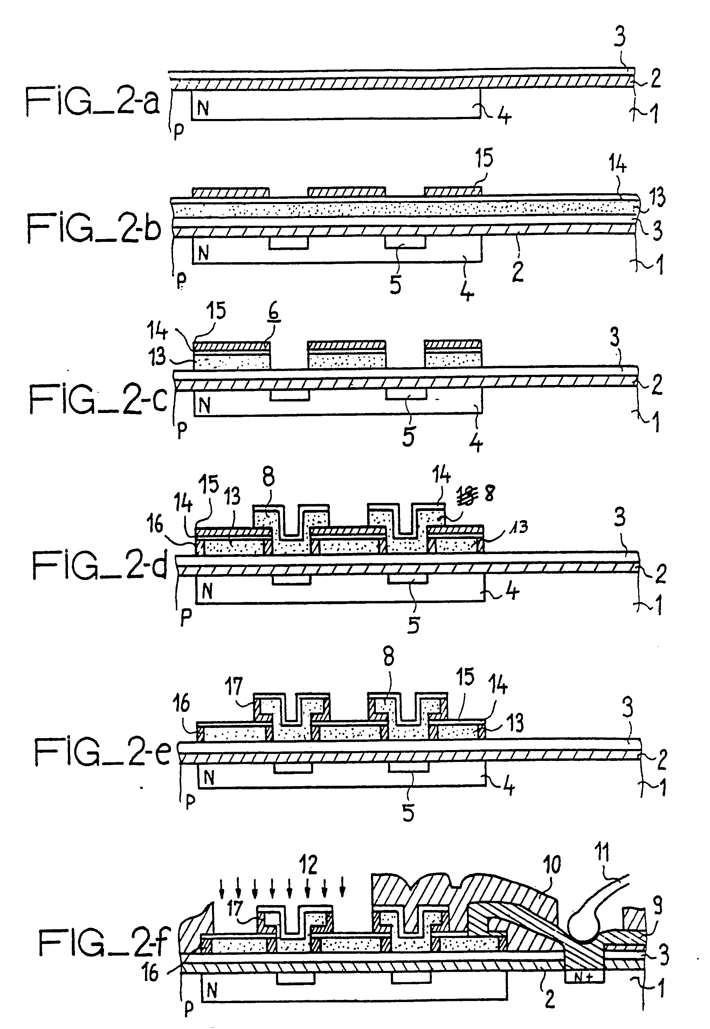

On décrira maintenant en se référant à un circuit intégré du même type que celui décrit avec référence aux figures 1a à 1e, le procédé de réalisation de la structure de grille de la présente invention. Les étapes à suivre jusqu'à la réalisation des implantations d'impuretés pour le canal enterré sont semblables dans les deux procédés. En conséquence, elles ne seront pas décrites à nouveau et la figure 2a représente une plaquette semblable à celle de la figure 1b. On réalise donc sur la plaquette de la figure 2a un premier niveau d'électrodes présentant une structure conforme à la présente invention. Pour se faire, on dépose une couche mince 13 de 1000 à 3000 Å de silicium polycristallin convenablement dopé que l'on recouvre d'une couche 14 de 800 à 1000 Å de nitrure de silicium. L'épaisseur de la couche de silicium polycristallin a été choisie de manière à présenter une resistance mécanique suffisante tout en ayant une bonne transparence, en particulier aux longueurs d'onde bleues. D'autre part, le nitrure de silicium qui présente un indice de réfraction de 2 est utilisé avec le silicium polycristallin de manière à réaliser une bonne adaptation d'indice. Eventuellement, on dépose sur la couche de nitrure de silicium soit une couche 15 de silicium polycristallin de 1000 Å à 1 µm d'épaisseur que l'on oxyde jusqu'à transformation en oxyde de silicium soit une couche d'oxyde de silicium. Dans les deux cas, l'epaisseur de cette couche d'oxyde est parfaitement délimitée. Il est alors possible de contrôler l'épaisseur de la couche d'oxyde ainsi obtenue et en conséquence la capacite créée entre les électrodes contigües. Ensuite on délimite et l'on grave par les techniques habituelles le premier niveau d'électrodes 6. Dans le cas d'une seule gravure, on ouvre à l'aide d'un masque les trois couches formées d'oxyde de silicium, de nitrure de silicium et de silicium polycristallin et l'on obtient le circuit représenté à la figure 2c. Dans le cas où une double gravure est nécessaire, on attaque tout d'abord uniquement la couche d'oxyde de silicium à l'aide d'un premier masque. On réalise ensuite une deuxième délimitation à l'aide d'un second masque et on élimine alors les trois couches d'oxyde de silicium, de nitrure de silicium et de silicium polycristallin comme représenté aux figures 2b et 2c.

On effectue alors l'oxydation thermique du silicium polycristallin. Le silicium polycristallin étant recouvert d'une couche de nitrure de silicium et d'oxyde de silicium, on obtient simplement une oxydation latérale 16 de la couche de silicium polycristallin.

Pour réaliser le deuxième niveau d'électrodes, on dépose à nouveau une couche mince de silicium polycristallin que l'on recouvre d'une couche de nitrure de silicium. Dans ce cas, la couche d'oxyde qui sert à isoler les deux niveaux d'électrodes n'a plus de raison d'être. On délimite et on grave, par attaque de la couche de nitrure de silicium et de silicium polycristallin, le deuxième niveau d'électrodes 8 comme représenté à la figure 2d. Puis on élimine la couche d'oxyde 15 qui recouvre le premier niveau d'électrodes. Cette élimination peut s'effectuer par attaque chimique de la couche d'oxyde de silicium. Ensuite, on effectue l'oxydation thermique de la plaquette et l'on transforme la partie latérale 17 de la couche de silicium polycristallin des électrodes 8 de second niveau en oxyde de silicium (voir figure 2e). Sur la plaquette ainsi obtenue, on réalise les mêmes opérations que mentionnées dans le mode de réalisation de l'art antérieur, pour obtenir la délimitation des contacts, des plots de soudure, de la zone photosensible, etc et on obtient en définitive la plaquette représentée à la figure 2f.

La structure de grille obtenue par le procédé décrit ci-dessus présente de nombreux avantages tels que:

- la possibilité de réaliser les électrodes avec une couche mince de silicium polycristallin convenablement dopé ce qui permet d'améliorer la transparence de l'électrode, ceci étant particulièrement avantageux pour les éléments photosensibles du type grille-isolant-semiconducteur des dispositifs photosensibles à transfert de charges;

- l'utilisation d'une couche de nitrure de silicium qui présente un indice de réfraction de 2 permettant de réaliser une meilleure adaptation d'indice entre les diverses couches;

- la possibilité de réduire les couplages entre électrodes ou grilles par réduction des capacités parasites ce qui entraine une augmentation de la vitesse de fonctionnement;

- l'augmentation de la densite d'integration du fait des épaisseurs réduites.

- La possibilité d'éliminer, par attaque chimique, par exemple, les oxydes déposés avant réalisation des contacts ou oxydes de passivation de l'aluminium, le nitrure de silicium constituant alors une couche d'arrêt avec une fonction de passivation vis à vis des zones actives et une fonction d'adaptation d'indice vis à vis des zones sensibles.

La présente invention à été décrite en se référant à un substrat en silicium et à une grille en silicium polycristallin, toutefois il est évident pour l'homme de l'art que l'on pourrait utiliser un substrat en un autre semiconducteur tel que l'arseniure de gallium et des grilles en oxydes métalliques tels que le bioxyde d'étain $SnO_2$.

La présente invention s'applique plus particulièrement aux dipositifs photosensibles fonctionnant avec des rayonnements visibles, proche de l'infrarouge ou des rayons X de l'ordre de 10 Å. Ces rayons sont fortement absorbés par les couches isolantes et la structure de la présente invention comportant une couche de $Si_3N_4$ de 800 Å au lieu d'une couche de $SiO_2$ de 1 µm est donc particulièrement favorable.

**Revendications**

1. Procédé de fabrication de circuits intégrés comportant des éléments du type grille-isolant-semiconducteur à au moins deux niveaux de grilles selon lequel:
- on réalise de manière habituelle dans le circuit intégré les zones d'isolement et/ou les implantations d'impuretés,
- on dépose sur la face supérieure du circuit une couche mince (13) de silicium polycristallin dopé semi-transparent,
- on recouvre cette couche d'une couche (14) d'un matériau isolant compatible présentant un indice de réfraction supérieur à 1,5,
- on délimite et grave par la technique habituelle un niveau de grilles,
- on réalise l'oxydation thermique latérale de la couche de silicium polycristallin de manière à obtenir une couche isolante (16) permettant de réaliser un autre niveau d'électrodes (8).

2. Procédé selon la revendication 1, caractérisé en ce que l'on dépose sur la couche (14) de matériau isolant présentant un indice de réfraction supérieur à 1,5 une couche supplémentaire (15) de matériau isolant d'épaisseur controlée avant réalisation de l'autre niveau de grilles.

3. Procédé selon la revendication 2, caractérisé en ce que l'autre couche (15) de matériau isolant est constituée par une couche d'oxyde ou par une couche de silicium polycristallin que l'on soumet à une oxydation thermique jusqu'à transformation complète en oxyde de silicium.

4. Procédé selon l'une quelconque des revendications 2 à 3, caractérisé en ce que, une fois le dernier niveau de grilles réalisé, on élimine la couche supplémentaire recouvrant l'avant-dernier niveau.

5. Procédé selon l'une quelconque des revendications 1 à 4, caractérisé en ce que le matériau isolant compatible est du nitrure de silicium.

## Patentansprüche

1. Verfahren zur Herstellung von integrierten Schaltungen, die Elemente vom Typ Gate-Isolator-Halbleiter mit wenigstens zwei Gateniveaus enthalten, bei welchem:
- in der integrierten Schaltung in üblicher Weise die Isolierzonen und/oder die Verunreinigungsimplantationen vorgenommen werden,
- auf der Oberseite der Schaltung eine Dünnschicht (13) aus polykristallinem, dotiertem, halbtransparentem Silizium aufgebracht wird,
- diese Schicht mit einer Schicht (14) aus einem Isoliermaterial bedeckt wird, welches kompatibel ist und einen Brechungsindex von größer als 1,5 aufweist,
- ein Gateniveau wird in üblicher Technik abgegrenzt und graviert,
- die thermische laterale Oxidation der Schicht aus polykristallinem Silizium wird in solcher Weise durchgeführt, daß eine Isolierschicht (16) erhalten wird, durch welche die Herstellung eines anderen Elektrodenniveaus (8) ermöglicht wird.

2. Verfahren nach Anspruch 1, dadurch gekennzeichnet, daß auf der Schicht (14) aus Isoliermaterial, die einen Brechungsindex von größer als 1,5 aufweist, eine zusätzliche Schicht (15) aus Isoliermaterial und von gesteuerter Dicke aufgebracht wird, bevor das andere Gateniveau hergestellt wird.

3. Verfahren nach Anspruch 2, dadurch gekennzeichnet, daß die weitere Schicht (15) aus Isoliermaterial durch eine Oxidschicht oder durch eine Schicht aus polykristallinem Silizium gebildet ist, das einer thermischen Oxidation bis zur vollständigen Umsetzung in Siliziumoxid unterzogen wird.

4. Verfahren nach Anspruch 2 oder 3, dadurch gekennzeichnet, daß, sobald das letzte Gateniveau hergestellt ist, die zusätzliche Schicht beseitigt wird, welche das vorletzte Niveau bedeckt.

5. Verfahren nach einem der Ansprüche 1 bis 4, dadurch gekennzeichnet, daß das kompatible Isoliermaterial Siliziumnitrid ist.

## Claims

1. Method of producing integrated circuits comprising elements of the type gate-insulation-semiconductor with at least two gate levels, wherein:
- the insulation zones and/or the impurity implantations are formed in the integrated circuit in the usual manner,
- a thin layer (13) of polycrystalline doped semi-transparent silicon is deposited on the upper face of the circuit,
- this layer is covered with a layer (14) of an insulating compatible material having an index of refraction exceeding 1.5,
- a gate level is defined and engraved by usual techniques,
- the thermal lateral oxidation of the layer of polycrystalline silicon is performed in a manner to obtain an insulating layer (16) permitting to form another electrode level (8).

2. Method according to claim 1, characterized in that an additional layer (15) of an insulating material of controlled thickness is deposited on the layer (14) of insulating material having an index of refraction exceeding 1.5, prior to the forming of the other gate level.

3. Method according to claim 2, characterized in that the other layer (15) of insulating material is constituted by an oxide layer or by a layer of polycrystalline silicon which is exposed to a thermal oxidation until complete transformation into silicon oxide.

4. Method according to any of claims 2 to 3, characterized in that, when the last gate level has been formed, the additional layer covering the penultimate level is eliminated.

5. Method according to any of claims 1 to 4, characterized in that the compatible insulating material is silicon nitride.

0 109 865

FIG_1-a

FIG_1-b

FIG_1-c

FIG_1-d

FIG_1-e

1

FIG_2-a

FIG_2-b

FIG_2-c

FIG_2-d

FIG_2-e

FIG_2-f